(19) Europäisches Patentamt

European Patent Office

Office européen des brevets

(11) **EP 0 597 255 B1**

(12) **EUROPÄISCHE PATENTSCHRIFT**

(45) Veröffentlichungstag und Bekanntmachung des Hinweises auf die Patenterteilung:
**07.01.1998  Patentblatt 1998/02**

(51) Int Cl.⁶: **H04H 1/00**

(21) Anmeldenummer: **93116295.2**

(22) Anmeldetag: **08.10.1993**

(54) **Empfänger für ein digitales Rundfunksignal, mit digitaler Signalverarbeitung**

Receiver for digital audio broadcast with digital signal processing

Récepteur pour radiodiffusion numérique avec traitement numérique de signaux

(84) Benannte Vertragsstaaten:
**AT CH DE FR GB IT LI**

(30) Priorität: **07.11.1992  DE 4237692**

(43) Veröffentlichungstag der Anmeldung:
**18.05.1994  Patentblatt 1994/20**

(73) Patentinhaber: **GRUNDIG Aktiengesellschaft 90762 Fürth (DE)**

(72) Erfinder: **Reis, Johannes, GRUNDIG E.M.V. D-90748 Fürth (DE)**

(56) Entgegenhaltungen:
**EP-A- 0 204 570          WO-A-88/10548
WO-A-91/02421**

• **IEEE TRANSACTIONS ON CONSUMER ELECTRONICS Bd. 35, Nr. 3 , August 1989 , NEW YORK US Seiten 504 - 511 O. KLANK, D. ROTTMANN 'DSR-Receiver for the digital sound broadcasting via the european satellites TVsat/TDF'**

**Beschreibung**

Die Erfindung geht aus von einem Empfänger nach dem Oberbegriff des Anspruchs 1.

Empfänger für Hörfunkübertragungen arbeiten heute meist nach dem analogen UKW-Übertragungsverfahren. Um die Übertragungsqualität zu verbessern, werden aber immer mehr digitale Verfahren eingesezt, wie beispielsweise beim Digital Satellite Radio, kurz DSR. Hierbei wird ein Sendesignal vom Sender via Satellit zum Empfänger übertragen. Um nicht jeden einzelnen Empfänger mit einer Antenne und einem ersten rauscharmen Mischer für den Satellitenfunk, die relativ groß bzw.teuer sind, auszustatten, kann ein DSR-Signal von einem zentralen terrestrischen Empfänger auch über Breitband-Kabelnetze dem Empfänger zugeleitet werden.

Für den mobilen Empfang in Kraftfahrzeugen oder mit tragbaren Geräten ist dieses Verfahren jedoch nicht praktikabel. Um auch für den mobilen Empfang ein Übertragungsverfahren bereitzustellen, das dem von digitalen Speichermedien (Digitale Compact Cassette, Compact-Disc) gebotenen Qualitätsstandard entspricht, wurde das Digital-Audio-Broadcasting, kurz DAB, entwickelt.

Bei diesem Übertragungsverfahren werden Einzelträgerfrequenzen, mit äquidistantem Frequenzabstand, in einem Frequenzbereich mit der Bandbreite B, gleichzeitig abgestrahlt. Dadurch werden Signalverzerrungen, die aus frequenzselektiven Feldstärkeschwankungen und Mehrwegeempfang resultieren, verhindert. Die einzelnen Träger sind mit jeweils einem Teil der digitalen Daten moduliert, wobei die Modulationsinhalte der einzelnen Träger für sämtliche Sendestationen des Sendegebietes identisch sind. Wird im Zeitmultiplex gearbeitet, können die Daten verschiedener Programme innerhalb der Datenpakete in zeitlicher Reihenfolge übertragen werden, so daß für einen Programmwechsel im Empfänger kein Wechsel der Abstimmfrequenzen, sondern nur ein Wechsel der zeitlich zugeordneten Dekodierung der Datenpakete erfolgen muß.

Ein digitales Übertragungssignal legt nahe, auch den dafür vorgesehen Empfänger möglichst weitgehend digital zu realisieren, um eine bestmögliche Empfangsqualität zu erreichen. Aus der DE-34 28 318 A1 ist ein solcher digitaler Synchrodyn-Empfänger bekannt. Bei diesem Empfänger wird das analoge Empfangssignal durch einen Mischer in ein Zwischenfrequenzsignal heruntergemischt, mit einem analogen Bandpaß bandbegrenzt, abgetastet, analog-digital gewandelt und in mindestens einem digitalen Signalprozessor mit einem komplexen Signal eines Oszillators multipliziert. Dadurch werden die Quadraturkomponenten des Empfangssignals im Basisband erzeugt.

Von Nachteil bei diesem Empfänger ist der große Aufwand bei der Weiterverarbeitung des analog-digital gewandelten Signals. Es ist mindestens ein digitaler Signalprozessor erforderlich, um eine Multiplikation mit einem komplexen Oszillatorsignal durchzuführen.

Aus der EP-0 201 758 B1 ist ein digitaler Demodulator für frequenzmodulierte Signale bekannt, der die Kompensation von Mehrwegeempfang ermöglicht. Auch bei diesem Demodulator wird das Empfangssignal zunächst in ein Zwischenfrequenzsignal heruntergemischt, bandbegrenzt und analog-digital gewandelt. Danach wird das digitale Signal einem Kaskadenentzerrer zugeleitet, der eine Reduzierung der im Eingangssignal enthaltenen Reflexionen bewirkt.

Dieser Demodulator weist den Nachteil auf, daß seine Realisierung, insbesondere aufgrund der kaskadierten Entzerrer, einen großen schaltungstechnischen Aufwand erfordert.

Aus der IEEE-Veröffentlichung Vol. AES-20, No. 6, November 1984, Seite 821-824, mit dem Titel "A simple method of sampling in-phase and quadrature components" ist eine Schaltungsanordnung bekannt, die ein Empfangssignal heruntermischt, bandbegrenzt, abtastet und analog-digital wandelt. Das digitale Signal wird unterabgetastet und zwei parallel geschalteten Allpaßfiltern zugeleitet, von denen einer die reelle Signalkomponente und der andere die imaginäre Signalkomponente des Eingangssignals ausgibt.

Bei dieser Schaltungsanordnung ist von Nachteil, daß mit einer sehr hohen Abtastrate gearbeitet wird, wodurch auch an den A/D-Wandler erhöhte Anforderungen hinsichtlich seiner Verarbeitungsgeschwindigkeit gestellt werden. Weiterhin sind die beiden verwendeten Allpaßfilter fünfter Ordnung mit einem großen schaltungstechnischen Aufwand verbunden.

Es ist daher die Aufgabe der vorliegenden Erfindung, einen Empfänger zu schaffen, der einfach realisierbar ist und weitgehend aus digitalen Schaltungen besteht, die integriert ausgeführt werden können. Der Empfänger soll weiterhin kostengünstig herstellbar und sehr platzsparend aufzubauen sein.

Diese Aufgabe wird bei dem erfindungsgemäßen Empfänger durch die im Patentanspruch 1 gekennzeichneten Merkmale gelöst.

Die erfindungsgemäße Empfängerschaltung weist den Vorteil auf, daß der Wert des Filterkoeffizienten des verwendeten Allpaßfilters geändert werden kann, wodurch nur ein einziger Allpaßfilter bei verringertem Schaltungsaufwand sowohl die reelle Signalkomponente als auch die imaginäre Signalkomponente erzeugt. Dadurch können auch Streuungen der Bauteile, die zu Phasenfehlern führen, vermieden werden. Weiterhin weist der verwendete Allpaßfilter den Vorteil auf, daß bei der Umschaltung des Wertes des Filterkoeffizienten eine Unterabtastung des Signals möglich ist, ohne einen zusätzlichen Schaltungsaufwand zu erfordern.

Der Empfänger nach Anspruch 2 weist den Vorteil auf, daß nur eine Demodulatorschaltung für die reelle und imaginäre Signalkomponente erforderlich ist, da die Signalkomponenten vom Allpaßfilter seriell ausgegeben werden. Weiterhin ist vorteilhaft, daß diese Demodulatorschaltung digital realisiert ist, wodurch die Schaltung besonders kostengünstig ist und integriert ausgeführt werden kann.

Der Empfänger nach Anspruch 3 weist den Vorteil auf, daß der Wert des Koeffizienten des Allpaßfilters mit der im A/D-Wandler verwendeten Abtastrate umgeschaltet wird. Dadurch wird aus einem ersten Abtastwert des Eingangssignals die reelle Signalkomponente und aus dem darauffolgenden Abtastwert des Eingangssignals die imaginäre Signalkomponente erzeugt. Da jeweils nur aus jedem zweiten Abtastwert des Eingangssignals die reelle oder imaginäre Signalkomponente extrahiert wird, entspricht dies gleichzeitig einer Unterabtastung mit dem Faktor zwei. Für diese Unterabtastung sind somit keine speziellen Verfahrensschritte oder Schaltungsanordnungen erforderlich. Weiterhin vorteilhaft ist dabei die zeitlich aufeinanderfolgende Ausgabe der reellen und imaginären Signalkomponenten.

Der Empfänger nach Anspruch 4 weist den Vorteil auf, daß die Multiplikation des digitalen Signals mit dem Filterkoeffizienten auf eine Summation zurückgeführt werden kann, wodurch der Schaltungsaufwand wesentlich verringert wird.

Der Empfänger nach Anspruch 5 weist den Vorteil auf, daß zum Heruntermischen der beiden Signalkomponenten ins Basisband lediglich das Komplement der Abtastwerte bei jeder zweiten reellen und jeder zweiten imaginären Signalkomponente gebildet werden muß. Dies entspricht einer Multiplikation der beiden Signalkomponenten mit der Folge von Abtastwerten einer Cosinus-Funktion, was zur Demodulation der beiden Signalkomponenten führt.

Der Empfänger nach Anspruch 6 weist den Vorteil auf, daß ein Bandpaß niedriger Ordnung zur Bandbegrenzung bei einer Zwischenfrequenz von 3072 kHz verwendet werden kann. Weiterhin kann durch die Wahl der Zwischenfrequenz eine Abtastrate des A/D-Wandlers von 4096 kHz gewählt werden, so daß das Eingangssignal im Zwischenfrequenzbereich analog-digital gewandelt wird und Periodisierungseffekte der Abtastung ausgenutzt werden können.

Der Empfänger nach Anspruch 7 weist den Vorteil auf, daß als Allpaß nur ein Filter niedriger Ordnung erforderlich ist.

Die Erfindung wird im folgenden anhand in den Zeichnungen dargestellter Ausführungsformen näher beschrieben und erläutert.

Es zeigt:

Fig. 1: ein Blockschaltbild des erfindungsgemäßen Empfängers,

Fig. 2a: ein Blockschaltbild des Allpaßfilters und des digitalen Demodulators,

Fig. 2b: die Steuersignale für die beiden Schalter des Allpaßfilters,

Fig. 3: ein Blockschaltbild des für die Integration geeigneten Empfängers und

Fig. 4: die Spektren der im Empfänger vorliegenden Signale.

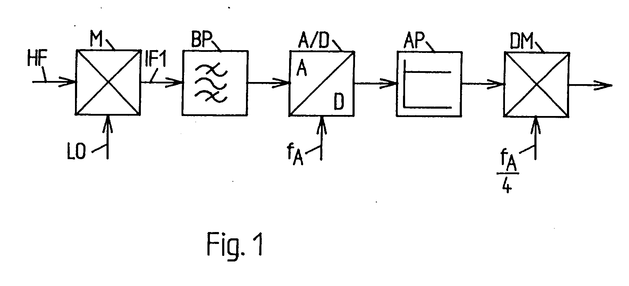

In Fig. 1 ist der Empfänger als Blockschaltbild dargestellt. Dieser besteht aus dem Mischer M, dem Bandpaß BP, dem A/D-Wandler A/D, dem Allpaß AP sowie dem digitalen Mischer DM. Das Empfangssignal mit der Mittenfrequenz HF wird zuerst in einem Mischer M mit einem Signal der Frequenz LO in eine Zwischenfrequenzlage bei der Mittenfrequenz IF1 heruntergemischt. Hierbei wird die Frequenz LO so gewählt, daß die Mittenfrequenz IF1 in der Zwischenfrequenzlage immer bei 3072 kHz liegt. Wird also die Übertragungsfrequenz bzw. der zur Übertragung benutzte Frequenzbereich verändert, so ändert sich die Frequenz LO, die Frequenz IF1 bleibt hingegen konstant. Das Signal in der Zwischenfrequenzlage IF1 wird anschließend durch einen Bandpaß BP bandbegrenzt. Dieser begrenzt das ZF-Signal auf den zur Informationsübertragung benutzten Frequenzbereich zwischen etwa 2200 kHz und 3800 kHz. Dieses Signal wird im A/D-Wandler zunächst mit der Abtastfrequenz $f_A$ = 4096 kHz abgetastet und anschließend in digitale Abtastwerte gewandelt. Anschließend folgt noch die Unterabtastung, Allpaßfilterung und die digitale Demodulation des digitalen Signals.

Die Schaltungsanordnungen, die diese Verfahrensschritte durchführen, sind in Fig. 2a detailliert dargestellt. Zunächst wird das Ausgangssignal des A/D-Wandlers A/D dem Allpaßfilter AP zugeleitet. Bei diesem Allpaßfilter AP wird der Schalter S1 für den Filterkoeffizienten APK mit der halben Abtastrate $f_A/2$ des A/D-Wandlers A/D umgeschaltet. Durch die Wahl dieser Umschaltfrequenz wird für einen Abtastwert des Eingangssignals entweder die reelle Signalkomponente oder die imaginäre erzeugt. Dies entspricht einer Unterabtastung mit dem Faktor zwei, da nicht für jeden Abtastwert des Eingangssignals die reelle und imaginäre Signalkomponente erzeugt wird. Die Steuerung des Schalters S1 erfolgt durch eine bereits vorhandene Steuereinheit des Empfängers.

Es wird ein erster Wert a für den Filterkoeffizienten APK so gewählt, daß das Ausgangssignal des Allpasses AP die reelle Signalkomponente des Eingangssignals ist, ein zweiter Wert b für den Filterkoeffizienten APK wird so gewählt, daß die imaginäre Signalkomponente des Eingangssignals ausgegeben wird.

Entsprechend den beiden Übertragungsfunktionen

$$H_a(z) = z^{-1}\frac{z^{-2} + a}{1 + a\,z^{-2}} \text{ und } H_b(z) = -\frac{z^{-2} + b}{1 + b\,z^{-2}}$$

zur wechselweisen Erzeugung der reellen und imaginären Signalkomponente des Eingangssignals wird ein Allpaßfilter mit einer umschaltbaren Übertragungsfunktion angegeben. Durch die Unterabtastung des Ausgangssignals des A/D-Wandlers A/D mit dem Faktor zwei wird der erste Faktor $z^{-1}$ der Übertragungsfunktion $H_a(z)$ realisiert. Der Faktor $z^{-1}$ bewirkt dabei lediglich eine Verzögerung um einen Abtastwert bzw. um eine Taktperiode der Abtastfrequenz $f_A$. Dies bedeutet, daß der Allpaßfilter AP zunächst die Übertragungsfunktion $H_b(z)$ realisiert. Danach wird das Ausgangssignal des A/D-Wandlers A/D mit dem Filterkoeffizienten APK multipliziert und additiv mit dem um zwei Taktperioden der Abtastfrequenz $f_A$ verzögerten Ausgangssignal des A/D-Wandlers A/D überlagert. Zu dem derart erzeugten Signal wird das mit dem Filterkoeffizienten APK multiplizierte und um zwei Taktperioden der Abtastfreqenz $f_A$ verzögerte Ausgangssignal dieses Addierers hinzuaddiert. Aus den beiden Übertragungsfunktionen $H_a(z)$ und $H_b(z)$ ersieht man, daß bei Verwendung des Wertes a als Filterkoeffizient APK die Übertragungsfunktion $H_a(z)$ aufgrund der Unterabtastung für jeden zweiten Wert realisiert ist. Soll die Übertragungsfunktion $H_b(z)$ realisiert werden, wird über einen Schalter S1 auf den Wert b für den Filterkoeffizienten APK umgeschaltet und zusätzlich wird das Ausgangssignal des Allpaßfilters AP, durch einen Schalter S2 umgeschaltet, mit -1 multipliziert.

Die Schalter S1 und S2 müssen daher mit der Abtastrate umgeschaltet werden und in ihrer Ausgangsstellung die Übertragungsfunktion $H_b(z)$ realisierten.

Im digitalen Mischer DM erfolgt anschließend die Abmischung ins Basisband. Hierfür wird das Ausgangssignal des Allpaßfilters AP mit einer Folge von Abtastwerten einer Cosinusfunktion der Frequenz $f_A/4$, den Werten 1 und -1, multipliziert. Es lassen sich nun die beiden Multiplikationen zur Realisierung der Übertragungsfunktion und zum Abmischen ins Basisband zusammenfassen, so daß nur noch eine Multiplikation erforderlich ist.

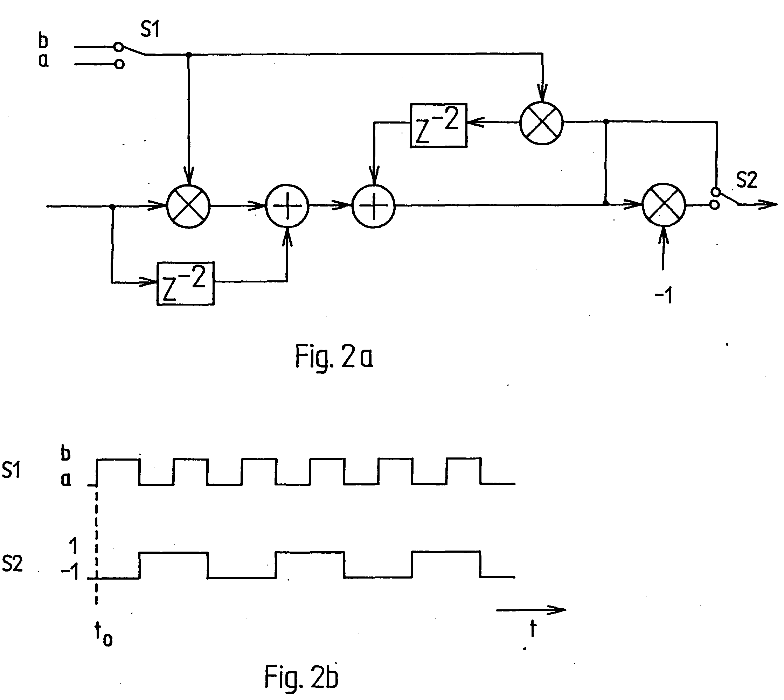

Da bei beiden Multiplikationen nur die Faktoren 1 und -1 auftreten, ergibt sich wieder eine Multiplikation mit 1 bzw. -1. Der genaue Verlauf der Steuersignale für die Schalter S1 und S2 ist in Fig. 2b in Abhängigkeit von der Zeit dargestellt.

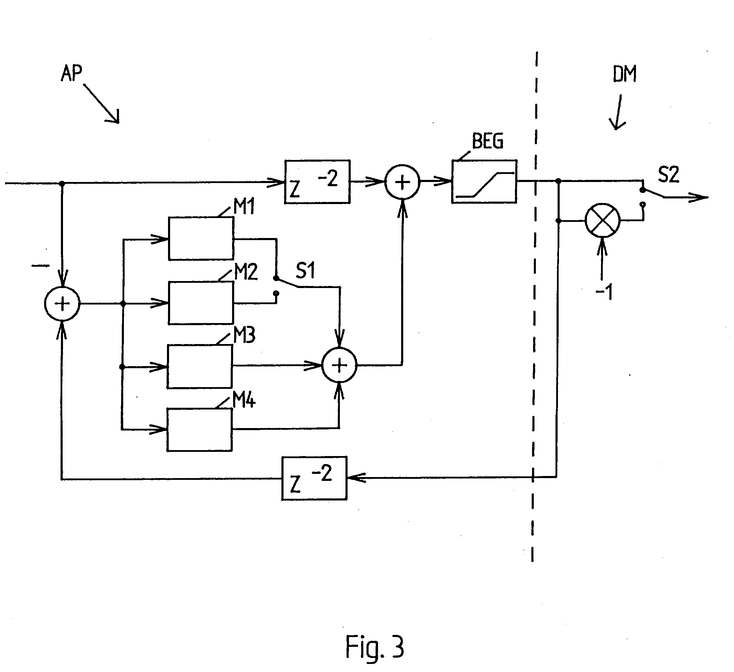

Fig. 3 zeigt einen für die Integration besonders gut geeigneten Schaltungsaufbau des Allpaßfilters AP und des digitalen Mischers DM aus Fig. 2a. Die negativen Ausgangsdaten des A/D-Wandlers A/D werden im Allpaßfilter AP zunächst mit den Ausgangsdaten des Allpaßfilters AP, die um zwei Taktperioden der halben Abtastfrequenz $f_A/2$ des A/D-Wandlers A/D verzögert wurden, additiv überlagert. Die derart erzeugten Werte werden anschließend mit dem Filterkoeffizienten APK multipliziert. Hierfür werden die beiden Werte a und b für den Filterkoeffizienten APK näherungsweise durch eine Summe aus Zweierpotenzen errechnet. Für den Wert a, der die reelle Signalkomponente des Eingangssignals erzeugt, wird näherungsweise $a \approx 2^{-1} + 2^{-3} + 2^{-4} = 0{,}6875$ verwendet. Für den Wert b, der die imaginäre Signalkomponente des Eingangssignals erzeugt, wird näherungsweise $b \approx 2^{-3} + 2^{-4} + 2^{-5} = 0{,}21875$ verwendet. Um die Multiplikation von a mit einem Signalwert zu realisieren, wird die Wertigkeit der einzelnen Datenleitungen, über die die Signalwerte übertragen werden, entsprechend den Exponenten der Zweierpotenzen geändert, und die Signalwerte auf Datenleitungen gleicher Wertigkeit aufsummiert. Für die Multiplikation mit dem Summand $2^{-1}$ wird beispielsweise bei einem 8 Bit breiten Datenbus der Datenleitung, der die Wertigkeit $2^0$ zugeordnet ist, die neue Wertigkeit $2^{-1}$ zugeordnet, der Datenleitung mit der Wertigkeit $2^1$ die neue Wertigkeit $2^0$ usw., bis zur Datenleitung mit der Wertigkeit $2^7$, der die Wertigkeit $2^6$ zugeordnet wird. Es erfolgt also eine Verschiebung um ein Bit hin zu kleineren Wertigkeiten der Datenleitungen, was einer Multiplikation mit $2^{-1}$ entspricht.

Anschließend werden die Signalwerte auf den Datenleitungen gleicher Wertigkeit aufsummiert, wobei ein Übertrag natürlich berücksichtigt wird. Soll die Breite des Datenbusses weiterhin 8 Bit betragen, werden alle Datenleitungen, denen eine Wertigkeit kleiner als $2^0$ zugewiesen wurde, nicht mehr aufsummiert, der über sie übertragene Signalwert wird vernachlässigt. Das macht es erforderlich, für die Summe der Zweierpotenzen etwas größere Werte zu wählen, als dies durch die exakten Werte für a und b gerechtfertigt erscheint. Um die Genauigkeit zu erhöhen, mit der im Allpaßfilter AP gerechnet wird, besteht die Möglichkeit, den Datenbus innerhalb des Allpaßfilters AP breiter auszuführen. Dadurch können die Berechnungen mit neun oder zehn Bit Genauigkeit durchgeführt werden.

Somit ergibt sich, daß die Summe der Signalwerte der Datenleitungen mit den alten Wertigkeiten $2^4$, $2^3$ und $2^1$ die neue Wertigkeit $2^0$ erhalten und aufsummiert werden. Das Ergebnis der Summation wird auf der Datenleitung mit der Wertigkeit $2^0$ weitergeleitet. Die Summe der Signalwerte der Datenleitungen mit den alten Wertigkeiten $2^5$, $2^4$ und $2^2$ erhalten die neue Wertigkeit $2^1$ und werden unter Beachtung eines eventuellen Übertrags aufsummiert. Um den Signalwert auf der Datenleitung mit der neuen Wertigkeit $2^4$ zu berechnen, sind nur die Signalwerte der Datenleitungen mit den alten Wertigkeiten $2^7$ und $2^5$ zuzüglich eines Übertrags zu addieren. Dadurch kann eine Multiplikation auf eine einfachere Addition zurückgeführt werden. Die Zuordnung der Wertigkeiten erfolgt einfach durch das Verbinden der Datenleitungen der erforderlichen alten Wertigkeiten mit den Eingängen des Addierers und dessen Ausgangswert wird auf die Datenleitung mit der neuen Wertigkeit gelegt.

Da sich die Summanden für den Wert a und b des Filterkoeffizienten APK nur durch $2^{-1}$ und $2^{-5}$ unterscheiden, wird die Umschaltung zwischen dem Wert a und b bereits durch ein Umschalten nur dieser zwei Summanden erreicht. Es wird also, wie in Fig. 3 dargestellt, bei der Summe aus verzögertem Ausgangssignal und Eingangssignal die Wertigkeit der einzelnen Datenleitungen in den Schaltungen M3 und M4 für die Summanden

$2^{-3}$ und $2^{-4}$, in der Schaltung M1 für den Summand $2^{-1}$ und in der Schaltung M2 für den Summand $2^{-5}$ neu festgelegt. Die Signalwerte werden anschließend addiert. Die Umschaltung zwischen Wert a und b, und damit zwischen reeller und imaginärer Signalkomponente, erfolgt durch eine Umschaltung zwischen den für die beiden Werte unterschiedlichen Summanden. Die Umschaltung erfolgt mit der halben Abtastfrequenz $f_A/2$, wie bei Fig. 2 bereits beschrieben. Im Anschluß daran wird das um einen Takt der halben Abtastfrequenz $f_A/2$ verzögerte Ausgangssignal des A/D-Wandlers A/D hinzuaddiert. Die derart berechneten Daten stehen nach einer Begrenzung BEG des Wertebereichs auf ± 127 bei einem 8 Bit breiten Datenbus zur digitalen Abmischung ins Basisband zur Verfügung.

Diese wird durch eine Multiplikation der Ausgangsdaten des Allpaßfilters AP mit 1 oder -1, den Abtastwerten einer Cosinusfunktion, erreicht, wie dies bei Fig. 2 erläutert ist. Die Multiplikation mit -1 erfolgt durch eine Komplementbildung des Ausgangsdatenwertes des Allpaßfilters AP. Dadurch kann auch diese Multiplikation auf eine einfachere Operation zurückgeführt werden.

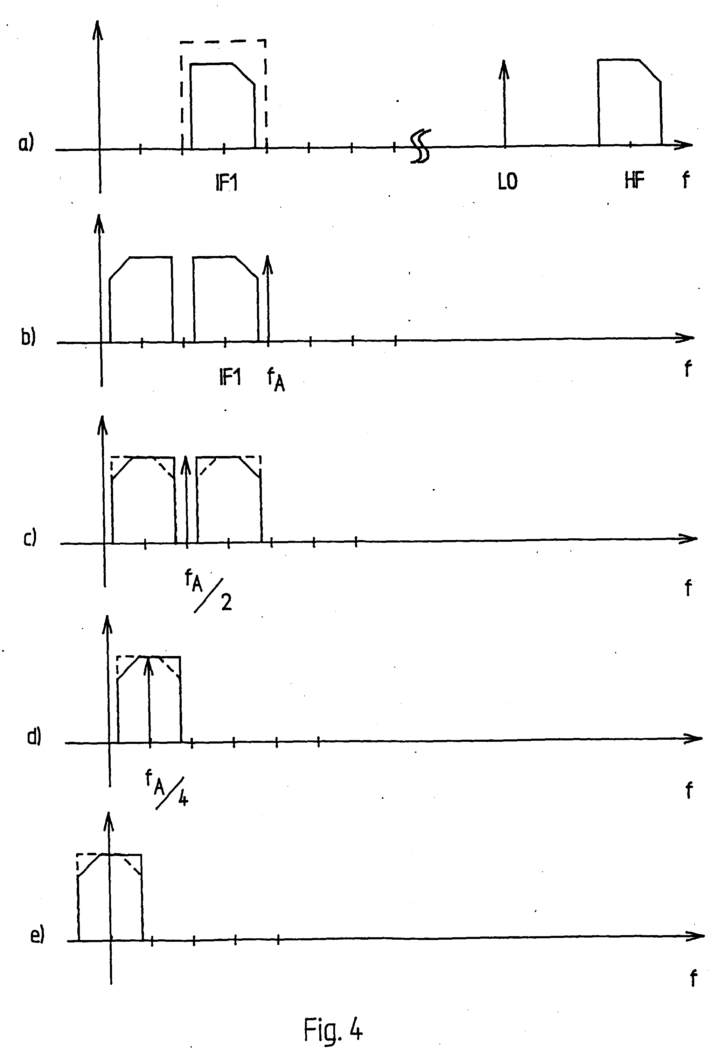

Fig. 4 a-e zeigt die im Empfänger entstehenden Signalspektren. Dabei sind nur die Signalanteile dargestellt, die für den Empfänger von Bedeutung sind. Fig. 4a zeigt das Eingangssignal des Empfängers beim DAB-Rundfunk, das eine gewisse Bandbreite hat, bei der Mittenfrequenz HF, sowie das Signal des lokalen Oszillators bei der Frequenz LO. Mit Hilfe dieses Signals wird das Eingangssignal in den Zwischenfrequenzbereich bei der Mittenfrequenz IF1 3072 kHz heruntergemischt. Diese Mittenfrequenz IF1 ist immer konstant, eine Veränderung der Mittenfrequenz HF des Empfangssignals wird durch eine Änderung der lokalen Oszillatorfrequenz LO wieder ausgeglichen. Die gestrichelte Linie symbolisiert die Filtercharakteristik der anschließenden Bandpaßfilterung.

Die Flankensteilheit des Bandpaßfilters BP kann wesentlich geringer als in Fig. 4a dargestellt sein.

In Fig. 4b ist das Spektrum nach der Bandpaßfilterung sowie die Frequenz $f_A$ der Abtastung im A/D-Wandler A/D eingezeichnet. Die Abtastung mit der Abtastfrequenz $f_A$ = 4096 khZ führt zu einer Periodisierung des Spektrums, so daß bei einer Mittenfrequenz von 1024 kHz das Signalspektrum in Kehrlage auftritt.

Fig. 4c zeigt das Ausgangssignal des Allpaßfilters AP. Durch die Aufspaltung des Empfangssignals in eine reelle (durchgezogene Linie) und eine imaginäre (unterbrochene Linie) Signalkomponente entstehen auch die entsprechenden Spektren, die durch die zusätzliche Unterabtastung mit der Abtastfrequenz $f_A/2$ = 2048 kHz ebenfalls periodisiert werden.

In Fig. 4d ist die Mischung im digitalen Mischer DM dargestellt. Das untere Seitenband aus Fig. 4c wird mit einer Frequenz $f_A/4$ demoduliert und ins Basisband übertragen, wie in Fig. 4e dargestellt. Das Basisbandsignal der reellen und imaginären Signalkomponente wird vom digitalen Demodulator DM ausgegeben und steht nun zur digitalen Weiterverarbeitung zur Verfügung.

## Patentansprüche

1. Empfänger für ein digitales Rundfunksignal, mit

   - einem Mischer (M), der ein Empfangssignal auf eine erste Zwischenfrequenz (IF1) heruntermischt,

   - einem Bandpaßfilter (BP), das das Ausgangssignal des Mischers (M) bandbegrenzt,

   - einem A/D-Wandler (A/D), der das bandbegrenzte Signal abtastet und digitalisiert,

   - einer Abtasteinrichtung, die das digitale Signal unterabtastet,

   - und Allpaßfiltern (AP), die eine reelle und eine imaginäre Signalkomponente erzeugen,

   **dadurch gekennzeichnet,** daß

   - nur ein einziges Allpaßfilter (AP) zur Erzeugung der reellen und imaginären Signalkomponenten verwendet wird,

   - dessen Filterkoeffizient (APK) durch eine Steuerschaltung derart veränderbar ist, daß zeitlich aufeinanderfolgend ein erster Wert (a) für den Filterkoeffizienten (APK) und die reelle Signalkomponente und danach ein zweiter Wert (b) für die imaginäre Signalkomponente als Ausgangssignal des Allpaßfilters (AP) erzeugt wird, wodurch mit der Umschaltung der Werte (a, b) für den Filterkoeffizienten (APK) gleichzeitig eine Unterabtastung des digitalen Signals durchgeführt wird.

2. Empfänger nach Anspruch 1,
   **dadurch gekennzeichnet,** daß die reelle und imaginäre Signalkomponente durch eine einzige digitale Mischerschaltung (DM) ins Basisband heruntergemischt wird.

3. Empfänger nach Anspruch 1 oder 2,
   **dadurch gekennzeichnet,** daß die Umschaltung der Werte (a, b) des Filterkoeffizienten (APK) des Allpaßfilters (AP) mit der Abtastrate ($f_A$) des A/D-Wandlers (A/D) erfolgt, daß durch diese Umschaltung abwechselnd eine reelle und eine imaginäre Signalkomponente erzeugt wird und daß durch die Umschaltung das digitale Signal mit dem Faktor zwei unterabgetastet wird.

4. Empfänger nach einem der Ansprüche 1 bis 3, **dadurch gekennzeichnet**, daß die Werte (a, b) des Filterkoeffizienten (APK) des Allpaßfilters (AP) aus einer Summe von Zweierpotenzen gebildet werden, wodurch eine einfache Multiplikation möglich ist.

5. Empfänger nach einem der Ansprüche 2, sowie 3 und 4 sofern abhängig von Anspruch 2, **dadurch gekennzeichnet**, daß die Mischung in der digitalen Mischerschaltung (DM) durch die Komplementbildung bei jeder zweiten reellen und jeder zweiten imaginären Signalkomponente erfolgt.

6. Empfänger nach einem der Ansprüche 1 bis 5, **dadurch gekennzeichnet,** daß die erste Zwischenfrequenz (IF1) bei 3072 kHz liegt und daß das bandbegrenzte Signal mit einer Abtastrate ($f_A$) von 4096 kHz abgetastet wird.

7. Empfänger nach einem oder mehreren der Ansprüche 1 bis 6, **dadurch gekennzeichnet,** daß das Allpaßfilter (AP) ein rekursives Filter zweiter Ordnung ist.

8. Verwendung des Empfängers nach einem der Ansprüche 1 bis 7 beim Digital Audio Broadcasting.

**Claims**

1. Receiver for a digital radio signal, comprising

    - a mixer (M) which down-mixes a received signal to a first intermediate frequency (IF1),
    - a band-pass filter (BP) which band-limits the output signal of the mixer (M),
    - an A/D converter (A/D) which samples and digitizes the band-limited signal,
    - a sampling device which undersamples the digital signal,
    - and all-pass filters (AP) which generate a real and an imaginary signal component,

    characterized in that

    - only a single all-pass filter (AP) is used to generate the real and imaginary signal components,
    - its filter coefficient (APK) can be varied by a control circuit in such a way that, sequentially in time, a first value (a) is generated for the filter coefficient (APK) and the real signal component, and then a second value (b) is generated for the imaginary signal component as output signal of the all-pass filter (AP), as a result of which an undersampling of the digital signal is simultaneously carried out with the switchover of the values (a, b) for the filter coefficient (APK).

2. Receiver according to Claim 1, characterized in that the real and imaginary signal component is down-mixed into the base band by a single digital mixer circuit (DM).

3. Receiver according to Claim 1 or 2, characterized in that the values (a, b) of the filter coefficient (APK) of the all-pass filter (AP) are switched over at the sampling rate ($f_A$) of the A/D converter (A/D), in that a real signal component and an imaginary signal component are generated alternately by this switchover, and in that the digital signal is undersampled by the factor two by the switchover.

4. Receiver according to one of Claims 1 to 3, characterized in that the values (a, b) of the filter coefficient (APK) of the all-pass filter (AP) are formed from a sum of powers of two, as a result of which a simple multiplication is possible.

5. Receiver according to one of Claims 2, and also 3 and 4, insofar as dependent on Claim 2, characterized in that the mixing in the digital mixer circuit (DM) is carried out by complement formation for every second real signal component and every second imaginary component.

6. Receiver according to one of Claims 1 to 5, characterized in that the first intermediate frequency (IF1) is 3072 kHz and in that the band-limited signal is sampled at a sampling rate ($f_A$) of 4096 kHz.

7. Receiver according to one or more of Claims 1 to 6, characterized in that the all-pass filter (AP) is a second-order recursive filter.

8. Use of the receiver according to one of Claims 1 to 7 in digital audio broadcasting.

**Revendications**

1. Récepteur pour un signal numérique de radiodiffusion, comportant

    - un mélangeur (M), qui réduit, par mélange, un signal de réception à une première fréquence intermédiaire (IF1),
    - un filtre passe-bande (BP), qui limite la bande du signal de sortie du mélangeur (M),
    - un convertisseur analogique/numérique (A/D), qui échantillonne et numérise le signal, dont la bande est limitée,
    - un dispositif d'échantillonnage, qui sous-échantillonne le signal numérique, et
    - des filtres passe-tout (AP), qui produisent une composante réelle et une composante imaginaire du signal,

caractérisé en ce que

- un seul filtre passe-tout (AP) est utilisé pour produire les composantes réelle et imaginaire du signal,
- le coefficient (APK) de ce filtre peut être modifié par un circuit de commande de telle sorte que successivement dans le temps une première valeur (a) pour le coefficient (APK) du filtre et la composante réelle du signal et ensuite une seconde valeur (b) pour la composante imaginaire du signal en tant que signal de sortie du filtre passe-tout (AP) sont produites, ce qui a pour effet qu'un sous-échantillonnage du signal numérique est effectué en même temps que s'effectue la commutation des valeurs (a, b) pour le coefficient (APK) du filtre.

2. Récepteur selon la revendication 1, caractérisé en ce que les composantes réelle et imaginaire du signal sont réduites en étant amenées dans la bande de base, par mélange à l'aide d'un seul circuit mélangeur numérique (DM).

3. Récepteur selon la revendication 1 ou 2, caractérisé en ce que la commutation des valeurs (a, b) du coefficient (APK) du filtre passe-tout (AP) s'effectue avec la cadence d'échantillonnage ($f_A$) du convertisseur analogique/numérique (A/D), qu'une composante réelle et une composante imaginaire du signal sont produites alternativement au moyen de cette commutation et que sous l'effet de cette commutation, le signal numérique est sous-échantillonné avec le facteur deux.

4. Récepteur selon l'une des revendications 1 à 3, caractérisé en ce que les valeurs (a, b) du coefficient (APK) du filtre passe-tout (AP) sont formées par une somme de puissances de deux, ce qui permet une multiplication simple.

5. Récepteur selon l'une des revendications 2 ainsi que 3 et 4, dans la mesure où elles dépendent de la revendication 2, caractérisé en ce que le mélange effectué dans le circuit mélangeur numérique (DM) est réalisé par formation du complément pour chaque seconde composante réelle et chaque seconde composante imaginaire du signal.

6. Récepteur selon l'une des revendications 1 à 5, caractérisé en ce que la première fréquence intermédiaire (IF1) est égale à 3072 kHz et que le signal, dont la bande est limitée, est échantillonné avec une cadence d'échantillonnage ($f_A$) de 4096 kHz.

7. Récepteur selon une ou plusieurs des revendications 1 à 6, caractérisé en ce que le filtre passe-tout (AP) est un filtre récursif du second ordre.

8. Utilisation du récepteur selon l'une des revendications 1 à 7, en radiodiffusion numérique.

Fig. 1

Fig. 2a

Fig. 2b

Fig. 3

Fig. 4